# EUROPEAN PATENT APPLICATION

(11) **EP 4 825 896 A1**
(43) Date of publication of application: **21.10.2026**
(21) Application number: 24903497.6
(22) Date of filing: 27.11.2024
(51) Int. Cl.: C08G 75/045, C08G 75/02, C08L 81/02, C08L 83/06, C09J 4/02, C09J 11/02, C09J 11/06, C09J 183/06, H01L 23/29, H01L 23/31

(54) **RESIN COMPOSITION, ADHESIVE AGENT, SEALING MATERIAL, CURED PRODUCT, SEMICONDUCTOR DEVICE, AND ELECTRONIC COMPONENT**

(30) Priority: 15.12.2023 JP 2023211994
(71) Applicant: Namics Corporation, Niigata-shi, Niigata 950-3131 (JP)
(72) Inventor: MITSUNUSHI Koki, Niigata-shi, Niigata 950-3131 (JP); SATO Ayako, Niigata-shi, Niigata 950-3131 (JP)
(74) Representative: Hoffmann Eitle
(86) International application number: PCT/JP2024/041925
(87) International publication number: WO 2025/126839

(57) **Abstract**

The object of the present invention is to provide at least a photo-curable or thermo-curable resin composition and an adhesive capable of suppressing the bleeding phenomenon.

Provided is a resin composition comprising:
(A) a polymerizable compound having a carbon-carbon double bond;
(B) a polythiol compound;
(C) a polymerization initiator; and
(D) a modified polydimethylsiloxane satisfying at least one of the following characteristics (a) and (b):
(a) an organic substituent containing a COOH group or an OH group is bonded to the polydimethylsiloxane directly or via a linker;
(b) in a ¹H NMR spectrum measured in deuterated chloroform, the modified polydimethylsiloxane has signals in ranges of 0.3 to -0.3 ppm and 4.4 to 3.2 ppm, and has a signal in a range of 13 to 0 ppm that disappears by addition of D₂O.

## Description

### Field of the Invention

The present invention relates to a resin composition, an adhesive or a sealing material comprising the same, a cured product thereof, and a semiconductor device and an electronic component comprising the cured product.

### Background Art

Currently, for assembling or mounting parts used in semiconductor devices, such as semiconductor chips, adhesives, sealing materials, and the like comprising a curable resin composition are often used for the purpose of maintaining reliability and the like. As such a resin composition, curable compositions using an epoxy compound or a (meth)acrylate compound as a main agent and a thiol-based compound as a curing agent are known (for example, Patent Documents 1 and 2).

Patent Document 3 discloses, as a photo- and thermo-curable resin composition that has both excellent photo-curability and excellent thermo-curability, and that, when light irradiation is performed under conditions such that a non-light-irradiated portion is generated, can subsequently be heated to completely cure the entire composition including the non-light-irradiated portion to produce a cured product with high adhesive strength, and also has good storage stability, a resin composition comprising: (1) a compound having a (meth)acryloyl group; (2) a polyene compound having two or more vinyl groups or allyl groups in one molecule; (3) a polythiol compound having two or more thiol groups in one molecule; (4) a photo-radical generator; (5) a thermal radical generator; and (6) a thermal anionic polymerization initiator.

### PRIOR ART REFERENCE

### Patent Document

Patent Document 1: Japanese Patent Application Laid-Open No. 2009-51954
Patent Document 2: International Publication No. WO 2005/052021
Patent Document 3: Japanese Patent Application Laid-Open No. 2017-101112

### Summary of the Invention

In an assembly process of a semiconductor module, bleeding is a problem. Bleeding is a phenomenon in which unreacted components ooze out from an adhesive application or a cured product over time when an adhesive containing a curable resin composition is used for fixing or bonding components, and the oozed components themselves are sometimes called "bleed." Contact of the bleed with a metal wiring portion on a substrate may cause an electrical failure, posing a problem that the reliability of the semiconductor module is lowered. In particular, inner bleeding generated from an uncured portion of the adhesive tends to progress when the adhesive application is left at room temperature and/or during thermal curing, and the bleed length tends to be long.

In recent years, electronic components such as semiconductor chips have been increasingly required to be downsized or highly integrated, and the distance to a wiring portion arranged around the electronic component is becoming shorter. In a semiconductor module including such downsized or highly integrated electronic components, there is a problem that the risk of contact between the bleed and the wiring portion increases due to the bleeding phenomenon.

Accordingly, an object of the present invention is to provide at least a photo-curable or thermo-curable resin composition and an adhesive capable of suppressing the bleeding phenomenon.

Specific means for solving the above problems are as follows. Embodiments of the present invention include a resin composition, an adhesive or a sealing material, a cured product, and a semiconductor device or an electronic component of the following aspects.
[1] A resin composition comprising:
   (A) a polymerizable compound having a carbon-carbon double bond;
   (B) a polythiol compound;
   (C) a polymerization initiator; and
   (D) a modified polydimethylsiloxane satisfying at least one of the following characteristics (a) and (b):
      (a) an organic substituent containing a COOH group or an OH group is bonded to the polydimethylsiloxane directly or via a linker;
      (b) in a ¹H NMR spectrum measured in deuterated chloroform, the modified polydimethylsiloxane has signals in ranges of 0.3 to -0.3 ppm and 4.4 to 3.2 ppm, and has a signal in a range of 13 to 0 ppm that disappears by addition of D₂O.
[2] The resin composition according to [1] above, wherein the (A) polymerizable compound having a carbon-carbon double bond is a (meth)acrylate compound.
[3] The resin composition according to [1] or [2] above, wherein a content of the (D) modified polydimethylsiloxane is 0.01 to 5% by mass relative to the total mass of the resin composition.
[4] The resin composition according to any one of [1] to [3] above, further comprising (E) a filler.
[5] An adhesive or a sealing material comprising the resin composition according to any one of [1] to [4] above.
[6] The adhesive or the sealing material according to [5] above, used for fixing, bonding, or protecting an optical sensor module or a component constituting the same.
[7] A cured product in which the resin composition according to any one of [1] to [4] above, or the adhesive or the sealing material according to [5] or [6] above has been cured.
[8] A semiconductor device or an electronic component comprising the cured product according to [7] above.
[9] The semiconductor device or the electronic component according to [8] above, which is an optical sensor module.

According to the embodiments of the present invention, there are provided: at least a photo-curable or thermo-curable resin composition capable of suppressing a bleeding phenomenon; an adhesive or a sealing material comprising the same; a cured product obtained by curing them; and a semiconductor device or an electronic component comprising the cured product.

### Mode for carrying out the Invention

### [Resin Composition]

A resin composition according to an embodiment of the present invention comprises:
(A) a polymerizable compound having a carbon-carbon double bond;
(B) a polythiol compound;
(C) a polymerization initiator; and
(D) a modified polydimethylsiloxane satisfying at least one of the following characteristics (a) and (b):
   (a) an organic substituent containing a COOH group or an OH group is bonded to the polydimethylsiloxane directly or via a linker;
   (b) in a ¹H NMR spectrum measured in deuterated chloroform, the modified polydimethylsiloxane has signals in ranges of 0.3 to -0.3 ppm and 4.4 to 3.2 ppm, and has a signal in a range of 13 to 0 ppm that disappears by addition of D₂O.
According to the present embodiment, it is possible to provide at least a photo-curable or thermo-curable resin composition capable of suppressing a bleeding phenomenon.

### (A) Polymerizable compound having a carbon-carbon double bond

The resin composition of the present embodiment comprises (A) a polymerizable compound having a carbon-carbon double bond (hereinafter also referred to as "(A) polymerizable compound" or "component (A)"). The (A) polymerizable compound having a carbon-carbon double bond undergoes polymerization through a radical polymerization reaction between the (A) polymerizable compounds or between the (A) polymerizable compound and a (B) polythiol compound described later, or through a crosslinking reaction between the (A) polymerizable compound and the (B) polythiol compound in an anionic polymerization system, thereby imparting curability and adhesiveness to the resin composition. Examples of the (A) polymerizable compound having a carbon-carbon double bond include, but are not limited to, (meth)acrylate compounds, maleimide compounds, styrene compounds, polybutadiene compounds, vinyl ether compounds, allyl ether compounds, and the like.

In the present specification, a (meth)acrylate compound is a compound having at least one (meth)acryloyl group in the molecule, and examples thereof include a monofunctional (meth)acrylate compound having one (meth)acryloyl group and a polyfunctional (meth)acrylate compound having two or more (meth)acryloyl groups. In the present embodiment, the (meth)acrylate compound is preferably a polyfunctional (meth)acrylate compound, or a combination of a polyfunctional (meth)acrylate compound and a monofunctional (meth)acrylate compound. In the present specification, the "(meth)acryloyl group" includes both a methacryloyl group and an acryloyl group. Further, the "(meth)acrylate compound" includes both an acrylate compound and a methacrylate compound.

Examples of the (meth)acrylate compound include, but are not limited to: polyfunctional (meth)acrylates such as diacrylate and/or dimethacrylate of tris(2-hydroxyethyl) isocyanurate; tris(2-hydroxyethyl) isocyanurate triacrylate and/or trimethacrylate; trimethylolpropane triacrylate and/or trimethacrylate, or oligomers thereof; pentaerythritol triacrylate and/or trimethacrylate, or oligomers thereof; polyacrylate and/or polymethacrylate of dipentaerythritol; tris(acryloxyethyl) isocyanurate; caprolactone-modified tris(acryloxyethyl) isocyanurate; caprolactone-modified tris(methacryloxyethyl) isocyanurate; polyacrylate and/or polymethacrylate of alkyl-modified dipentaerythritol; polyacrylate and/or polymethacrylate of caprolactone-modified dipentaerythritol; ethoxylated bisphenol A diacrylate and/or ethoxylated bisphenol A dimethacrylate; dihydrocyclopentadienyl acrylate and/or dihydrocyclopentadienyl methacrylate, as well as polyester acrylate and/or polyester methacrylate, dimethylol-tricyclodecane diacrylate, poly(meth)acrylate of ditrimethylolpropane, ethoxylated bisphenol A diacrylate, polyurethane having two or more (meth)acryloyl groups in one molecule, and polyester having two or more (meth)acryloyl groups in one molecule; and monofunctional (meth)acrylates such as phenoxyethyl acrylate, 2-(*o*-phenylphenoxy)ethyl acrylate, isobornyl acrylate, phenoxydiethene glycol (meth)acrylate, 4-*tert*-butylcyclohexyl acrylate, and epoxy resin half acrylate.

From the viewpoint of reactivity, the (meth)acrylate compound is preferably an acrylate compound that is substantially free of a methacrylate compound.

As the (meth)acrylate compound, any one type may be used, or two or more types may be used in combination.

Maleimide compounds include a monofunctional maleimide compound having one maleimide group and a polyfunctional maleimide compound having two or more maleimide groups, and in particular, a maleimide compound having two maleimide groups may be referred to as a bismaleimide compound. Examples of the bismaleimide compound include, but are not limited to: N,N'-(4,4'-diphenylmethane)bismaleimide; bisphenol A diphenyl ether bismaleimide; 3,3'-dimethyl-5,5'-diethyl-4,4'-diphenylmethane bismaleimide; 4-methyl-1,3-phenylene bismaleimide; 1,6'-bismaleimide-(2,2,4-trimethyl)hexane; *bis*-(3-ethyl-5-methyl-4-maleimidophenyl)methane; *m*-phenylene bismaleimide (N,N'-1,3-phenylene bismaleimide); 1,6-bismaleimide hexane; 1,2-bismaleimide ethane (N,N'-ethylene dimaleimide); N,N'-(1,2-phenylene)bismaleimide; N,N'-1,4-phenylene dimaleimide; N,N'-(sulfonyldi-p-phenylene)dimaleimide; and N,N'-[3,3'-(1,3-phenylenedioxy)diphenyl]bismaleimide. These may be used alone, or two or more types thereof may be used in combination.

In a case where a low elastic modulus at room temperature is required for a cured product of the resin composition, the bismaleimide compound is preferably a bismaleimide compound having a hydrocarbon group derived from a dimer acid. Such a bismaleimide compound is described in, for example, Japanese Unexamined Patent Application Publication No. 2015-193725. Examples of commercially available bismaleimide compounds having a hydrocarbon group derived from a dimer acid include, but are not limited to: product name "BMI-689", product name "BMI-1500", and product name "BMI-1700" which are liquid at 25°C; or product name "BMI-3000" which is solid at 25°C (all manufactured by Designer Molecules Inc.). These may be used alone, or two or more types thereof may be used in combination.

A styrene compound is a compound having at least one styrene group (H₂C=CH-C₆H₅-). Examples of the styrene compound include, but are not limited to: 1,2-*bis*(*p*-vinylphenyl)ethane; 1,2-bis(*m*-vinylphenyl)ethane; 1-(*p*-vinylphenyl)-2-(*m-*vinylphenyl)ethane; *bis*(*p*-vinylphenyl)methane; *bis*(*m*-vinylphenyl)methane; *p-*vinylphenyl-*m*-vinylphenylmethane; 1,4-*bis*(*p*-vinylphenyl)benzene; *1,4-bis(m-*vinylphenyl)benzene; 1-(*p*-vinylphenyl)-4-(*m*-vinylphenyl)benzene; *1,3-bis(p-*vinylphenyl)benzene; 1,3-*bis*(*m*-vinylphenyl)benzene; 1-(*p*-vinylphenyl)-3-(*m-*vinylphenyl)benzene; 1,6-*bis*(*p*-vinylphenyl)hexane; 1,6-*bis*(*m*-vinylphenyl)hexane; 1-(*p*-vinylphenyl)-6-(*m*-vinylphenyl)hexane; and a divinylbenzene polymer (oligomer) having a vinyl group in a side chain. These may be used alone, or two or more types thereof may be used in combination.

Examples of the polybutadiene compound include, but are not limited to: polybutadiene having a vinyl group in a side chain; and polybutadiene in which 1,2-bonds in the structure account for 90% by weight or more. These may be used alone, or two or more types thereof may be used in combination.

A vinyl ether compound is a compound having at least one vinyl ether group (H₂C=CH-O-). Examples of the vinyl ether compound include, but are not limited to: ethyl vinyl ether; triethylene glycol divinyl ether; trimethylolpropane trivinyl ether; hydroxybutyl vinyl ether; vinyl ether of 1,4-cyclohexanedimethanol; dodecyl vinyl ether; and cyclohexyl vinyl ether. These may be used alone, or two or more types thereof may be used in combination.

Examples of the allyl ether compound include, but are not limited to: allyl glycidyl ether; trimethylolpropane diallyl ether; pentaerythritol triallyl ether; and glycerin monoallyl ether. These may be used alone, or two or more types thereof may be used in combination.

Component (A) preferably has a viscosity of 0.01 to 100 Pa·s from the viewpoints of preparation of the resin composition and dispensability. In the present specification, the viscosity refers to a value measured at a measurement temperature of 25°C using an appropriate viscometer according to the viscosity range.

Examples of commercially available products of component (A) include, but are not limited to: polyester acrylate (product name: EBECRYL 810) manufactured by Daicel-Allnex Ltd.; ditrimethylolpropane tetraacrylate (product name: EBECRYL 140) manufactured by Daicel-Allnex Ltd.; polyester acrylate (product name: M7100) manufactured by Toagosei Co., Ltd.; dimethylol-tricyclodecane diacrylate (product name: LIGHT ACRYLATE DCP-A) manufactured by Kyoeisha Chemical Co., Ltd.; neopentyl glycol-modified trimethylolpropane diacrylate (product name: KAYARAD R-604) manufactured by Nippon Kayaku Co., Ltd.; 2-(o-phenylphenoxy)ethyl acrylate (product name: HRD-01) manufactured by Nisshoku Techno Fine Chemical Co., Ltd.; and ethoxylated bisphenol A diacrylate (product name: ABE-300) manufactured by Shin-Nakamura Chemical Co., Ltd. As component (A), any one of these may be used, or two or more types thereof may be used in combination.

The content of component (A) is preferably 10 to 70% by mass, and more preferably 20 to 60% by mass, relative to the total mass of the resin composition, from the viewpoint of the adhesive strength of the resin composition.

### (B) Polythiol compound

The resin composition of the present embodiment comprises (B) a polythiol compound (hereinafter also referred to as "component (B)"). The (B) polythiol compound imparts high curability to the resin composition. Component (B) is not particularly limited as long as it is bifunctional or higher, that is, it has two or more thiol groups. Component (B) preferably comprises a trifunctional or higher thiol compound, and more preferably comprises a trifunctional and/or tetrafunctional thiol compound. Note that the trifunctional and tetrafunctional thiol compounds refer to thiol compounds having three and four thiol groups, respectively.

Examples of the polythiol compound include, but are not limited to: pentaerythritol tetrakis(3-mercaptopropionate); trimethylolpropane tris(3-mercaptopropionate); dipentaerythritol hexakis(3-mercaptopropionate); pentaerythritol tetrakis(3-mercaptobutyrate); tris-[(3-mercaptopropionyloxy)-ethyl]-isocyanurate; pentaerythritol tetrakis(3-mercaptobutyrate); 1,4-bis(3-mercaptobutyryloxy)butane; 1,3,5-tris(3-mercaptobutyryloxyethyl)-1,3,5-triazine-2,4,6(1H, 3H, 5H)-trione; trimethylolpropane tris(3-mercaptobutyrate); and trimethylolethane tris(3-mercaptobutyrate).

Examples of commercially available products of the component (B) include, but are not limited to: trimethylolpropane tris(3-mercaptopropionate) (manufactured by SC Organic Chemical Co., Ltd.: TMMP); tris-[(3-mercaptopropionyloxy)-ethyl]-isocyanurate (manufactured by SC Organic Chemical Co., Ltd.: TEMPIC); pentaerythritol tetrakis(3-mercaptopropionate) (manufactured by SC Organic Chemical Co., Ltd.: PEMP); tetraethylene glycol bis(3-mercaptopropionate) (manufactured by SC Organic Chemical Co., Ltd.: EGMP-4); dipentaerythritol hexakis(3-mercaptopropionate) (manufactured by SC Organic Chemical Co., Ltd.: DPMP); pentaerythritol tetrakis(3-mercaptobutyrate) (manufactured by Showa Denko K.K.: Karenz MT^{®} PE1); 1,3,5-tris(3-mercaptobutyryloxyethyl)-1,3,5-triazine-2,4,6(1H, 3H, 5H)-trione (manufactured by Showa Denko K.K.: Karenz MT^{®} NR1); and trimethylolpropane tris(3-mercaptobutyrate) (manufactured by Showa Denko K.K.: Karenz MT^{®} TPMB).

Further, examples of the (B) polythiol compound include glycoluril compounds represented by the following general formula (1).

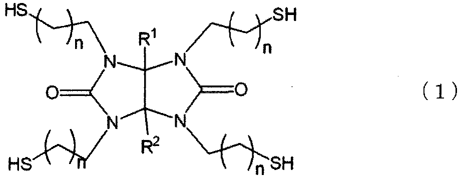

In the general formula (1), R¹ and R² each independently represent hydrogen, an alkyl group having 1 to 10 carbon atoms, or a phenyl group. n is an integer of 0 to 10.

Further, component (B) may be a compound represented by the following chemical formula (2) or chemical formula (3).

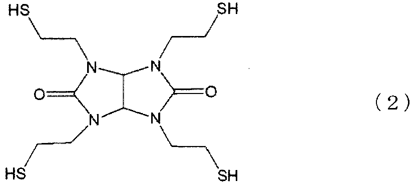

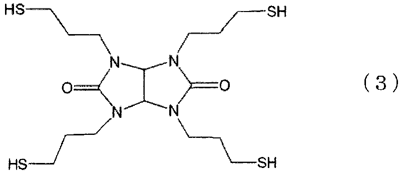

Furthermore, examples of the (B) polythiol compound include polythiol compounds represented by the general formula (4).

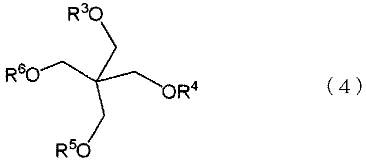

In the general formula (4), R³, R⁴, R⁵, and R⁶ each independently represent hydrogen or CₙH₂ₙSH (n is 2 to 6). Furthermore, at least one of R³, R⁴, R⁵, and R⁶ is CₙH₂ₙSH (n is 2 to 6). For the polythiol compound of component (B) represented by the general formula (4), n is preferably 2 to 4 from the viewpoint of curability. Moreover, this polythiol compound more preferably has a mercaptopropyl group where n is 3, from the viewpoint of the balance between the physical properties of a cured product and the curing rate. Since component (B) represented by the general formula (4) itself has a sufficiently flexible skeleton, it is effective when it is desired to lower the elastic modulus of a cured product. By adding component (B) represented by the general formula (4), the elastic modulus of the cured product can be controlled, so that the adhesive strength (particularly peel strength) after curing can be increased.

Examples of commercially available products of the component (B) include, but are not limited to: thiol glycoluril derivatives manufactured by Shikoku Chemicals Corporation (product names: TS-G (corresponding to chemical formula (2), thiol equivalent: 100 g/eq) and C3 TS-G (corresponding to chemical formula (3), thiol equivalent: 114 g/eq)); and a thiol compound manufactured by SC Organic Chemical Co., Ltd. (product name: PEPT (corresponding to general formula (4), thiol equivalent: 124 g/eq)).

Other examples of the component (B) include: 1,3,4,6-tetrakis(mercaptomethyl) glycoluril; 1,3,4,6-tetrakis(mercaptomethyl)-3a-methylglycoluril; 1,3,4,6-tetrakis(2-mercaptoethyl)-3a-methylglycoluril; 1,3,4,6-tetrakis(3-mercaptopropyl)-3a-methylglycoluril; 1,3,4,6-tetrakis(mercaptomethyl)-3a,6a-dimethylglycoluril; 1,3,4,6-tetrakis(2-mercaptoethyl)-3a,6a-dimethylglycoluril; 1,3,4,6-tetrakis(3-mercaptopropyl)-3a,6a-dimethylglycoluril; 1,3,4,6-tetrakis(mercaptomethyl)-3a,6a-diphenylglycoluril; 1,3,4,6-tetrakis(2-mercaptoethyl)-3a,6a-diphenylglycoluril; 1,3,4,6-tetrakis(3-mercaptopropyl)-3a,6a-diphenylglycoluril; 3-[2,3-bis(3-sulfanylpropoxy)propoxy]propane-1-thiol; 3-[2,2-bis[(3-mercaptopropoxy)methyl]butoxy]-1-propanethiol; pentaerythritol tetrapropanethiol; 1,2,3-tris(mercaptomethylthio)propane; 1,2,3-tris(2-mercaptoethylthio)propane; 1,2,3-tris(3-mercaptopropylthio)propane; 4-mercaptomethyl-1,8-dimercapto-3,6-dithiaoctane; 5,7-dimercaptomethyl-1,11-dimercapto-3,6,9-trithiaundecane; 4,7-dimercaptomethyl-1,11-dimercapto-3,6,9-trithiaundecane; 4,8-dimercaptomethyl-1,11-dimercapto-3,6,9-trithiaundecane; tetrakis(mercaptomethylthiomethyl)methane; tetrakis(2-mercaptoethylthiomethyl)methane; tetrakis(3-mercaptopropylthiomethyl)methane; 1,1,3,3-tetrakis(mercaptomethylthio)propane; 1,1,2,2-tetrakis(mercaptomethylthio)ethane; 1,1,5,5-tetrakis(mercaptomethylthio)-3-thiapentane; 1,1,6,6-tetrakis(mercaptomethylthio)-3,4-dithiahexane; 2,2-bis(mercaptomethylthio)ethanethiol; 3-mercaptomethylthio-1,7-dimercapto-2,6-dithiaheptane; 3,6-bis(mercaptomethylthio)-1,9-dimercapto-2,5,8-trithianonane; 3-mercaptomethylthio-1,6-dimercapto-2,5-dithiahexane; 1,1,9,9-tetrakis(mercaptomethylthio)-5-(3,3-bis(mercaptomethylthio)-1-thiapropyl)3,7-dithianonane; tris(2,2-bis(mercaptomethylthio)ethyl)methane; tris(4,4-bis(mercaptomethylthio)-2-thiabutyl)methane; tetrakis(2,2-bis(mercaptomethylthio)ethyl)methane; tetrakis(4,4-bis(mercaptomethylthio)-2-thiabutyl)methane; 3,5,9,11-tetrakis(mercaptomethylthio)-1,13-dimercapto-2,6,8,12-tetrathiatridecane; 3,5,9,11,15,17-hexakis(mercaptomethylthio)-1,19-dimercapto-2,6,8,12,14,18-hexathianonadecane; 9-(2,2-bis(mercaptomethylthio)ethyl)-3,5,13,15-tetrakis(mercaptomethylthio)-1,17-dimercapto-2,6,8,10,12,16-hexathiaheptadecane; 3,4,8,9-tetrakis(mercaptomethylthio)-1,11-dimercapto-2,5,7,10-tetrathiaundecane; 3,4,8,9,13,14-hexakis(mercaptomethylthio)-1,16-dimercapto-2,5,7,10,12,15-hexathiahexadecane; 8-[bis(mercaptomethylthio)methyl]-3,4,12,13-tetrakis(mercaptomethylthio)-1,15-dimercapto-2,5,7,9,11,14-hexathiapentadecane; 4,6-bis[3,5-bis(mercaptomethylthio)-7-mercapto-2,6-dithiaheptylthio]-1,3-dithiane; 4-[3,5-bis(mercaptomethylthio)-7-mercapto-2,6-dithiaheptylthio]-6-mercaptomethylthio-1,3-dithiane; 1,1-bis[4-(6-mercaptomethylthio)-1,3-dithianylthio]-1,3-bis(mercaptomethylthio)propane; 1-[4-(6-mercaptomethylthio)-1,3-dithianylthio]-3-[2,2-bis(mercaptomethylthio)ethyl]-7,9-bis(mercaptomethylthio)-2,4,6,10-tetrathiaundecane; 3-[2-(1,3-dithietanyl)]methyl-7,9-bis(mercaptomethylthio)- 1,11-dimercapto-2,4,6,10-tetrathiaundecane; 9-[2-(1,3-dithietanyl)]methyl-3,5,13,15-tetrakis(mercaptomethylthio)-1,17-dimercapto-2,6,8,10,12,16-hexathiaheptadecane; 3-[2-(1,3-dithietanyl)]methyl-7,9,13,15-tetrakis(mercaptomethylthio)-1,17-dimercapto-2,4,6,10,12,16-hexathiaheptadecane; 4,6-bis[4-(6-mercaptomethylthio)-1,3-dithianylthio]-6-[4-(6-mercaptomethylthio)-1,3-dithianylthio]-1,3-dithiane; 4-[3,4,8,9-tetrakis(mercaptomethylthio)-11-mercapto-2,5,7,10-tetrathiaundecyl]-5-mercaptomethylthio-1,3-dithiolane; 4,5-bis[3,4-bis(mercaptomethylthio)-6-mercapto-2,5-dithiahexylthio]-1,3-dithiolane; 4-[3,4-bis(mercaptomethylthio)-6-mercapto-2,5-dithiahexylthio]-5-mercaptomethylthio-1,3-dithiolane; 4-[3-bis(mercaptomethylthio)methyl-5,6-bis(mercaptomethylthio)-8-mercapto-2,4,7-trithiaoctyl]-5-mercaptomethylthio-1,3-dithiolane; 2- {bis[3,4-bis(mercaptomethylthio)-6-mercapto-2,5-dithiahexylthio]methyl}-1,3-dithietane; 2-[3,4-bis(mercaptomethylthio)-6-mercapto-2,5-dithiahexylthio]mercaptomethylthiomethyl-1,3-dithietane; 2-[3,4,8,9-tetrakis(mercaptomethylthio)-11-mercapto-2,5,7,10-tetrathiaundecylthio]mercaptomethylthiomethyl-1,3-dithietane; 2-[3-bis(mercaptomethylthio)methyl-5,6-bis(mercaptomethylthio)-8-mercapto-2,4,7-trithiaoctyl]mercaptomethylthiomethyl-1,3-dithietane; and 4- {1-[2-(1,3-dithietanyl)]-3-mercapto-2-thiapropylthio}-5-[1,2-bis(mercaptomethylthio)-4-mercapto-3-thiabutylthio]-1,3-dithiolane.

As component (B), any one type may be used, or two or more types may be used in combination.

In the present embodiment, the content of component (B) in the resin composition is preferably 1 to 70% by mass, more preferably 10 to 60% by mass, and even more preferably 20 to 50% by mass, relative to the total mass of the resin composition.

Among the polythiol compounds, there is a polythiol compound having a hydrolyzable partial structure such as an ester bond in the molecule (that is, hydrolyzable). From the viewpoint of the moisture resistance of a cured product of the resin composition, the amount of the polythiol compound having a hydrolyzable partial structure such as an ester bond in the molecule is preferably 90% by mass or less relative to the total mass of component (B), and is, for example, 0 to 90% by mass, for example, 0 to 80% by mass, for example, 0 to 70% by mass, for example, 0 to 60% by mass, or for example, 0 to 50% by mass.

### (C) Polymerization initiator

The resin composition of the present embodiment comprises (C) a polymerization initiator (hereinafter also referred to as "component (C)"). In the present specification, the (C) polymerization initiator includes (C1) a basic catalyst, (C2) a photobase generator, (C3) a photo-radical polymerization initiator, and (C4) a thermal radical polymerization initiator. The (C) polymerization initiator can be appropriately selected according to the application site or use of the resin composition, or according to, for example, whether the resin composition is made to be photocurable, thermosetting, or both photo- and thermosetting. For example, as the (C) polymerization initiator, any one of (C1) the basic catalyst, (C2) the photobase generator, (C3) the photo-radical polymerization initiator, and (C4) the thermal radical polymerization initiator may be used alone, or these may be used in any combination.

### (C1) Basic catalyst

As the (C1) basic catalyst, a known basic catalyst can be used, but a thermal latent catalyst is preferable. The thermal latent catalyst is a compound or substance that is in an inactive state at room temperature and is activated by heating to function as a polymerization catalyst, and examples thereof include: amine compounds that are solid at normal temperature; amine adduct-based latent polymerization catalysts such as reaction products of an amine compound and an epoxy compound (amine-epoxy adduct system), and reaction products of an amine compound and an isocyanate compound or a urea compound (urea-type adduct system); microcapsule-type thermal latent polymerization catalysts; and solid-dispersion-type thermal latent polymerization catalysts such as inclusion-type thermal latent polymerization catalysts. The amine compounds include aliphatic amines, aromatic amines, and heterocyclic amines.

Examples of the amine compound that is solid at normal temperature include, but are not limited to: dicyandiamide; 2-heptadecylimidazole; 2-phenyl-4,5-dihydroxymethylimidazole; 2-undecylimidazole; 2-phenyl-4-methyl-5-hydroxymethylimidazole; 2-phenyl-4-benzyl-5-hydroxymethylimidazole; 2,4-diamino-6-(2-methyl-1-imidazolyl-(1))-ethyl-S-triazine; 2,4-diamino-6-(2'-methylimidazolyl-(1)')-ethyl-S-triazine/isocyanuric acid adduct; 2-methylimidazole; 2-phenylimidazole; 2-phenyl-4-methylimidazole; 1-cyanoethyl-2-phenylimidazole; 1-cyanoethyl-2-methylimidazole-trimellitate; 1-cyanoethyl-2-phenylimidazole-trimellitate; N-(2-methylimidazolyl-1-ethyl)-urea; and N,N'-(2-methylimidazolyl-(1)-ethyl)-adipoyldiamide.

The amine compound used as one of the raw materials for producing the amine adduct-based latent curing catalyst may be any compound having, in the molecule, at least one active hydrogen capable of undergoing an addition reaction with an epoxy group or an isocyanate group, and having, in the molecule, at least one functional group selected from a primary amino group, a secondary amino group, and a tertiary amino group. Examples of such amine compounds include, but are not limited to: in addition to the amine compounds that are solid at normal temperature, aliphatic amines such as diethylenetriamine, triethylenetetramine, n-propylamine, 2-hydroxyethylaminopropylamine, cyclohexylamine, and 4,4'-diaminodicyclohexylmethane; aromatic amine compounds such as 4,4'-diaminodiphenylmethane and 2-methylaniline; and nitrogen-containing heterocyclic amine compounds such as 2-ethyl-4-methylimidazole, 2-ethyl-4-methylimidazoline, 2,4-dimethylimidazoline, piperidine, and piperazine.

Among these, compounds having a tertiary amino group in the molecule and imidazole derivatives are raw materials that provide latent curing catalysts having excellent curing acceleration capability. Examples of such compounds include, but are not limited to: amine compounds such as dimethylaminopropylamine, diethylaminopropylamine, di-n-propylaminopropylamine, dibutylaminopropylamine, dimethylaminoethylamine, diethylaminoethylamine, and N-methylpiperazine; imidazole compounds such as 2-methylimidazole, 2-ethylimidazole, 2-ethyl-4-methylimidazole, 2-phenylimidazole, 2-phenyl-4,5-dihydroxymethylimidazole, 2-phenyl-4-methyl-5-hydroxymethylimidazole, 2-phenyl-4-methylimidazole, and 1-(2-aminoethyl)-2-methylimidazole; and alcohols, phenols, thiols, carboxylic acids, and hydrazides having a tertiary amino group or an imidazole skeleton in the molecule, such as 2-dimethylaminoethanol, 1-methyl-2-dimethylaminoethanol, 1-phenoxymethyl-2-dimethylaminoethanol, 2-diethylaminoethanol, 1-butoxymethyl-2-dimethylaminoethanol, 1-(2-hydroxy-3-phenoxypropyl)-2-methylimidazole, 1-(2-hydroxy-3-phenoxypropyl)-2-ethyl-4-methylimidazole, 1-(2-hydroxy-3-butoxypropyl)-2-methylimidazole, 1-(2-hydroxy-3-butoxypropyl)-2-ethyl-4-methylimidazole, 1-(2-hydroxy-3-phenoxypropyl)-2-phenylimidazoline, 1-(2-hydroxy-3-butoxypropyl)-2-methylimidazoline, 2-(dimethylaminomethyl)phenol, 2,4,6-tris(dimethylaminomethyl)phenol, N-β-hydroxyethylmorpholine, 2-dimethylaminoethanethiol, 2-mercaptopyridine, benzimidazole, 2-mercaptobenzimidazole, 2-mercaptobenzothiazole, 4-mercaptopyridine, N,N-dimethylaminobenzoic acid, N,N-dimethylglycine, nicotinic acid, isonicotinic acid, picolinic acid, N,N-dimethylglycine hydrazide, N,N-dimethylpropionic acid hydrazide, nicotinic acid hydrazide, and isonicotinic acid hydrazide.

Examples of the epoxy compound used as one of the raw materials for producing the amine-epoxy adduct-based thermal latent curing catalyst include, but are not limited to, polyglycidyl ethers obtained by reacting epichlorohydrin with a polyhydric phenol such as bisphenol A, bisphenol F, catechol, or resorcinol, or a polyhydric alcohol such as glycerin or polyethylene glycol; glycidyl ether esters obtained by reacting epichlorohydrin with a hydroxycarboxylic acid such as p-hydroxybenzoic acid or β-hydroxynaphthoic acid; polyglycidyl esters obtained by reacting epichlorohydrin with a polycarboxylic acid such as phthalic acid or terephthalic acid; glycidylamine compounds obtained by reacting epichlorohydrin with 4,4'-diaminodiphenylmethane, m-aminophenol, or the like; and further, polyfunctional epoxy compounds such as epoxidized phenol novolac resins, epoxidized cresol novolac resins, and epoxidized polyolefins, and monofunctional epoxy compounds such as butyl glycidyl ether, phenyl glycidyl ether, various phenylphenol glycidyl ethers, and glycidyl methacrylate.

Examples of the isocyanate compound used as one of the raw materials for producing the amine-urea adduct-based latent curing catalyst include: monofunctional isocyanate compounds such as n-butyl isocyanate, isopropyl isocyanate, phenyl isocyanate, and benzyl isocyanate; polyfunctional isocyanate compounds such as hexamethylene diisocyanate, toluylene diisocyanate, 1,5-naphthalene diisocyanate, diphenylmethane-4,4'-diisocyanate, isophorone diisocyanate, xylylene diisocyanate, para-phenylene diisocyanate, 1,3,6-hexamethylene triisocyanate, and bicycloheptane triisocyanate; and further, terminal isocyanate group-containing compounds and the like obtained by a reaction between these polyfunctional isocyanate compounds and an active hydrogen compound. Examples of such terminal isocyanate group-containing compounds include, but are not limited to, an addition compound having a terminal isocyanate group obtained by a reaction between toluylene diisocyanate and trimethylolpropane, and an addition compound having a terminal isocyanate group obtained by a reaction between toluylene diisocyanate and pentaerythritol.

Examples of the urea compound used as one of the raw materials for producing the amine-urea adduct-based latent curing catalyst include, but are not limited to, urea and thiourea.

The amine adduct-based thermal latent curing catalyst is, for example, a combination of: (a) two components of the amine compound and an epoxy compound; (b) three components of these two components and an active hydrogen compound; or (c) two or three components of the amine compound and an isocyanate compound and/or a urea compound. These can be easily produced by taking and mixing each component, reacting them at a temperature from room temperature to 200°C, followed by cooling and solidification and then pulverization; or by reacting them in a solvent such as methyl ethyl ketone, dioxane, or tetrahydrofuran, and then pulverizing the solid content after removal of the solvent.

The microcapsule-type latent curing catalyst is a curing catalyst having a structure in which a core, which is an amine compound or an amine adduct compound obtained by a reaction between an amine compound and an epoxy compound, an isocyanate compound, or a urea compound, is coated with a shell made of a synthetic resin or an inorganic oxide. Examples of the amine compound include the amine compounds described above. An imidazole derivative is preferable as the amine compound because it exhibits suitable latency. Examples of the imidazole derivative include 2-methylimidazole, 2-phenylimidazole, 2-phenyl-4-methylimidazole, 2-phenyl-4,5-dihydroxymethylimidazole, and 2-phenyl-4-methyl-5-hydroxymethylimidazole. Examples of the synthetic resin serving as the shell include phenol resins, melamine resins, epoxy resins, urethane resins, and urea resins, and these resins can also be used in combination. Examples of the inorganic oxide serving as the shell include silica, alumina, titania, and magnesia.

Representative examples of commercially available products of the thermal latent curing catalyst include, but are not limited to, the following. Examples of the amine-epoxy adduct-based curing catalyst include, but are not limited to: "AMICURE (AJICURE) PN-23" (product name, manufactured by Ajinomoto Fine-Techno Co., Inc.), "AMICURE (AJICURE) PN-40" (product name, manufactured by Ajinomoto Fine-Techno Co., Inc.), "AMICURE (AJICURE) PN-50" (product name, manufactured by Ajinomoto Fine-Techno Co., Inc.), "HARDENER X-3661S" (product name, manufactured by ACR Co., Ltd.), "HARDENER X-3670S" (product name, manufactured by ACR Co., Ltd.), "NOVACURE HX-3742" (product name, manufactured by Asahi Kasei Corp.), "NOVACURE HX-3721" (product name, manufactured by Asahi Kasei Corp.), "NOVACURE HXA9322HP" (product name, manufactured by Asahi Kasei Corp.), "NOVACURE HXA3922HP" (product name, manufactured by Asahi Kasei Corp.), "NOVACURE HXA3932HP" (product name, manufactured by Asahi Kasei Corp.), "NOVACURE HXA5945HP" (product name, manufactured by Asahi Kasei Corp.), "NOVACURE HXA5911HP" (product name, manufactured by Asahi Kasei Corp.), and "NOVACURE HXA9382HP" (product name, manufactured by Asahi Kasei Corp.). The aforementioned "NOVACURE" series are also microcapsule-type latent curing catalysts. Further, examples of the amine-urea adduct-based curing catalyst include, but are not limited to: "FUJICURE FXE-1000" (product name, manufactured by T&K TOKA CO., LTD.), "FUJICURE FXR1020" (product name, manufactured by T&K TOKA CO., LTD.), "FUJICURE FXR-1030" (product name, manufactured by T&K TOKA CO., LTD.), "FUJICURE FXR1121" (product name, manufactured by T&K TOKA CO., LTD.), "FUJICURE FXR1081" (product name, manufactured by T&K TOKA CO., LTD.), "FUJICURE 1061" (product name, manufactured by T&K TOKA CO., LTD.), and "FUJICURE 1171" (product name, manufactured by T&K TOKA CO., LTD.).

The inclusion-type thermal latent curing catalyst is a curing catalyst having a structure in which guest molecules such as an amine compound are confined in molecular units within a crystal space formed by host molecules. Examples of commercially available inclusion-type thermal latent curing catalysts include "NISSOCURE TIC-188" (product name, manufactured by Nippon Soda Co., Ltd.).

As the (C1) basic catalyst, any one type may be used, or two or more types may be used in combination.

When the resin composition contains the (C1) basic catalyst, the content of the (C1) basic catalyst is preferably 0.1 to 40% by mass, and more preferably 1 to 20% by mass, relative to the total mass of the resin composition, from the viewpoint of the curing rate and pot life of the resin composition.

### (C2) Photobase generator

The photobase generator absorbs light to generate a base as an active species, thereby allowing the polymerization of an anionic polymerizable compound to proceed. Examples of the photobase generator include, but are not limited to, various compounds that generate amines, amidines, guanidines, phosphazenes, carbenes, or the like as a base. Specific examples of the photobase generator include, but are not limited to: 2-benzyl-2-(dimethylamino)-1-[4-(morpholino)phenyl]-1-butanone; 2-(dimethylamino)-2-(4-methylbenzyl)-1-(4-morpholinophenyl)butan-1-one; 2-nitrobenzyl 4-hydroxypiperidine-1-carboxylate; 4,5-dimethoxy-2-nitrobenzyl 2,6-dimethylpiperidine-1-carboxylate; 1-(9,10-dioxo-9,10-dihydroanthracen-2-yl)ethyl cyclohexylcarbamate; 1-(9,10-dioxo-9,10-dihydroanthracen-2-yl)ethyl 1H-imidazole-1-carboxylate; 3,4,6,7,8,9-hexahydro-2H-pyrimido[1,2-a]pyrimidin-1-ium 2-(3-benzoylphenyl)propanoate; diaminomethaniminium 2-(3-benzoylphenyl)propanoate; (Z)-N-(((bis(dimethylamino)methylene)amino)(isopropylamino)methylene)propan-2-aminium 2-(3-benzoylphenyl)propanoate; 1,2-dicyclohexyl-4,4,5,5-tetramethylbiguanidium n-butyltriphenylborate; (Z)-{[bis(dimethylamino)methylidene]amino}-N-cyclohexyl(cyclohexylamino)methaniminium tetrakis(3-fluorophenyl)borate; 1,2-diisopropyl-3-[bis(dimethylamino)methylene]guanididm 2-(3-benzoylphenyl)propionate; 9-anthrylmethyl N,N-diethylcarbamate; (E)-1-piperidino-3-(2-hydroxyphenyl)-2-propen-1-one; 2-nitrophenylmethyl 4-methacryloyloxypiperidine-1-carboxylate; tetramethylguanididium tetrakis(3-fluorophenyl)borate; tetramethylguanididium tetrakis(4-fluorophenyl)borate; a salt containing protonated DBU and a tetrakis(3-fluorophenyl)borate anion; and a salt containing benzylated DBU and a tetrakis(3-fluorophenyl)borate anion. These may be used alone or in combination of two or more types.

As the (C2) photobase generator, any one type may be used, or two or more types may be used in combination.

When the resin composition contains the (C2) photobase generator, the content of the (C2) photobase generator in the resin composition is preferably 0.1 to 15 parts by mass, and more preferably 0.5 to 10 parts by mass, relative to a total of 100 parts by mass of the (A) polymerizable compounds.

### (C3) Photo-radical polymerization initiator

The photo-radical polymerization initiator absorbs light to generate radicals as active species, thereby allowing the polymerization of a radical polymerizable compound to proceed. Examples of the photo-radical polymerization initiator include, but are not limited to, alkylphenone-based compounds, acylphosphine oxide-based compounds, and oxime-based compounds.

Examples of the alkylphenone-based compounds include: benzyl dimethyl ketals such as 2,2-dimethoxy-1,2-diphenylethan-1-one (Omnirad 651 manufactured by IGM Resins B.V. as a commercially available product); α-aminoalkylphenones such as 2-methyl-2-morpholino(4-thiomethylphenyl)propan-1-one (Omnirad 907 manufactured by IGM Resins B.V. as a commercially available product); α-hydroxyalkylphenones such as 1-hydroxy-cyclohexyl-phenyl-ketone (Omnirad 184 manufactured by IGM Resins B.V. as a commercially available product); 2-dimethylamino-2-(4-methylbenzyl)-1-(4-morpholin-4-yl-phenyl)-butan-1-one (Omnirad 379EG manufactured by IGM Resins B.V. as a commercially available product), and 2-benzyl-2-(dimethylamino)-4'-morpholinobutyrophenone (Omnirad 369 manufactured by IGM Resins B.V. as a commercially available product).

Examples of the acylphosphine oxide-based compounds include 2,4,6-trimethylbenzoyl-diphenyl-phosphine oxide (Omnirad TPO H manufactured by IGM Resins B.V. as a commercially available product), bis(2,4,6-trimethylbenzoyl)-phenylphosphine oxide (Omnirad 819 manufactured by IGM Resins B.V. as a commercially available product), and the like.

Examples of the oxime-based compounds include: 2-(benzoyloxyimino)-1-[4-(phenylthio)phenyl]-1-octanone (Irgacure OXE01 sold by BASF Japan Ltd. as a commercially available product); 6-[1-(acetyloxyimino)ethyl]-9-ethyl-9H-carbazol-3-yl (2-methylphenyl) ketone (Irgacure OXE02 sold by BASF Japan Ltd. as a commercially available product); [8-[[(acetyloxy)imino][2-(2,2,3,3-tetrafluoropropoxy)phenyl]methyl]-11-(2-ethylhexyl)-11H-benzo[a]carbazol-5-yl]-(2,4,6-trimethylphenyl)methanone (Irgacure OXE03 sold by BASF Japan Ltd. as a commercially available product); and Irgacure OXE04 sold by BASF Japan Ltd. as a commercially available product.

Examples of the (C3) photo-radical polymerization initiator include, in addition to the photo-radical polymerization initiators described above: 2-hydroxy-2-methyl-1-phenylpropan-1-one; diethoxyacetophenone; 1-(4-isopropylphenyl)-2-hydroxy-2-methylpropan-1-one; 1-(4-dodecylphenyl)-2-hydroxy-2-methylpropan-1-one; 4-(2-hydroxyethoxy)-phenyl(2-hydroxy-2-propyl)ketone; 2-methyl-1-[4-(methylthio)phenyl]-2-morpholinopropane-1-one; benzoin; benzoin methyl ether; benzoin ethyl ether; benzoin isopropyl ether; benzoin n-butyl ether; benzoin phenyl ether; benzyl dimethyl ketal; benzophenone; benzoylbenzoic acid; methyl benzoylbenzoate; 4-phenylbenzophenone; hydroxybenzophenone; acrylated benzophenone; 4-benzoyl-4'-methyldiphenyl sulfide; 3,3'-dimethyl-4-methoxybenzophenone; thioxanthone; 2-chlorothioxanthone; 2-methylthioxanthone; 2,4-dimethylthioxanthone; isopropylthioxanthone; 2,4-dichlorothioxanthone; 2,4-diethylthioxanthone; 2,4-diisopropylthioxanthone; 2,4,6-trimethylbenzoyldiphenylphosphine oxide; methylphenylglyoxylate; benzil; camphorquinone; and the like.

When the resin composition contains the (C3) photo-radical polymerization initiator, the content of the (C3) photo-radical polymerization initiator is preferably 0.01 to 10 parts by mass, and more preferably 0.1 to 8 parts by mass, relative to 100 parts by mass of the (A) polymerizable compounds, from the viewpoint of photocurability.

### (C4) Thermal radical polymerization initiator

The thermal radical polymerization initiator generates radicals as active species by heat, thereby allowing the polymerization of a radical polymerizable compound to proceed. The thermal radical polymerization initiator that can be used is not particularly limited, and known materials can be used. Specific examples of the thermal radical polymerization initiator include, but are not limited to: dialkyl peroxides such as dicumyl peroxide, t-butyl cumyl peroxide, 1,3-bis(2-t-butylperoxyisopropyl)benzene, or 2,5-dimethyl-2,5-bis(t-butylperoxy)hexane; peroxyketals such as 1,1-bis(t-butylperoxy)cyclohexane, 1,1-bis(t-butylperoxy)-3,3,5-trimethylcyclohexane, 1,1-bis(t-amylperoxy)cyclohexane, 2,2-bis(t-butylperoxy)butane, n-butyl 4,4-bis(t-butylperoxy)valerate, or ethyl 3,3-(t-butylperoxy)butyrate; and alkyl peroxyesters such as t-butylperoxy 2-ethylhexanoate, 1,1,3,3-tetramethylbutylperoxy-2-ethylhexanoate, t-butylperoxy isobutyrate, t-butylperoxy maleate, or t-butylperoxy benzoate. As the thermal radical polymerization initiator, any one type may be used, or two or more types may be used in combination.

When the resin composition contains the (C4) thermal radical polymerization initiator, the content of the (C4) thermal radical polymerization initiator is preferably 0.01 to 5% by mass, and more preferably 0.1 to 3% by mass, relative to the total mass of the resin composition.

### (D) Modified polydimethylsiloxane

The resin composition of the present embodiment contains (D) a modified polydimethylsiloxane (hereinafter, also referred to as "component (D)"). In the present embodiment, the (D) modified polydimethylsiloxane satisfies at least one of the following characteristics (a) and (b):
(a) An organic substituent containing a COOH group or an OH group is bonded to the polydimethylsiloxane directly or via a linker.
(b) In a ¹H NMR spectrum measured in deuterated chloroform, it has signals in the ranges of 0.3 to -0.3 ppm and 4.4 to 3.2 ppm, and has a signal in the range of 13 to 0 ppm that disappears upon addition of D₂O.

More specifically, the modified polydimethylsiloxane has a structure in which an organic substituent as a modifying group is introduced into a side chain and/or a terminal of a polydimethylsiloxane main chain composed of dimethylsiloxane repeating units represented by the formula: 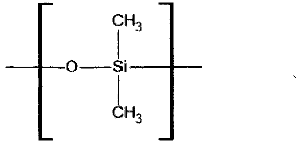 directly or via a linker such as an alkyl group or an alkylene group. Here, "an organic substituent is introduced into a side chain of the polydimethylsiloxane main chain" means that a part of the methyl groups of the polydimethylsiloxane main chain is substituted with the organic substituent. "An organic substituent is introduced into a terminal of the polydimethylsiloxane main chain" means that a terminal (for example, a methyl group or -OSi(CH₃)₃) of the polydimethylsiloxane main chain is substituted with the organic substituent. The introduction position of the modifying group of the modified polydimethylsiloxane may be any of a side chain, a terminal (one terminal or both terminals), and both a side chain and a terminal. Further, the modified polydimethylsiloxane also includes a polydimethylsiloxane having a Gemini structure. The degree of polymerization (the number of dimethylsiloxane repeating units) of the modified polydimethylsiloxane is not particularly limited and is, for example, 3 or more, and preferably 5 or more.

In the modified polydimethylsiloxane according to the above characteristic (a), the organic substituent contains a COOH group or an OH group.

Examples of the modified polydimethylsiloxane in which the organic substituent contains a COOH group include those commercially available under names such as carboxyl-modified polydimethylsiloxane or carboxyl-modified silicone. Examples of such commercially available products include, but are not limited to, products sold by Shin-Etsu Chemical Co., Ltd. under the product names: X-22-3701E, X-22-162C, X-22-3710, and the like.

Whether or not the organic substituent of the modified polydimethylsiloxane contains a COOH group can also be confirmed by observing the presence or absence of an IR spectrum at approximately 1715 cm⁻¹ derived from the C=O stretching vibration of carboxylic acid, through Fourier transform infrared spectroscopy (FT-IR) measurement of the modified polydimethylsiloxane.

Examples of the modified polydimethylsiloxane in which the organic substituent contains an OH group include those commercially available under names such as carbinol-modified polydimethylsiloxane or carbinol-modified silicone. Examples of such commercially available products include, but are not limited to, products sold by Shin-Etsu Chemical Co., Ltd. under the product names: X-22-4039, X-22-4015, KF-6000, KF-6001, KF-6002, KF-6003, X-22-170BX, X-22-170DX, and the like.

Other examples of the modified polydimethylsiloxane in which the organic substituent contains an OH group include those called polyether-modified polydimethylsiloxane or polyether-modified silicone, in which the terminal of the polyether group is an OH group. Examples of such commercially available products include, but are not limited to, products sold by Shin-Etsu Chemical Co., Ltd. under the product names: X-22-4272, KF-6123, and the like. In addition, such polyether-modified polydimethylsiloxane or polyether-modified silicone may be named "PEG-(number) dimethicone" in the cosmetic labeling name. "PEG-(number)" means that it has a PEG chain where n is the average of said number. "PEG-(number) dimethicone" is expressed as "PEG-(n) DIMETHICONE" in the INCI nomenclature. Examples thereof include, but are not limited to: PEG-9 dimethicone (product name: KF-6013); PEG-3 dimethicone (product name: KF-6015, sold by Shin-Etsu Chemical Co., Ltd.); PEG-10 dimethicone (product name: KF-6017, sold by Shin-Etsu Chemical Co., Ltd.); and PEG-10 dimethicone (product name: KF-6043, sold by Shin-Etsu Chemical Co., Ltd.).

Examples of the polyether group as the organic substituent include a polyethylene glycol group and a polypropylene glycol group, and a polyethylene glycol group is preferred.

Reactive silicones whose hydroxyl value is disclosed in catalogs or the like can also be presumed to be the modified polydimethylsiloxane in which the organic substituent contains an OH group. The presence of an OH group in the modified polydimethylsiloxane may be confirmed by measuring the hydroxyl value of the modified polydimethylsiloxane. In one aspect, the modified polydimethylsiloxane has a hydroxyl value of 1 mg KOH/g or more. The measurement of the hydroxyl value can be performed, for example, by a method compliant with JIS K 0070, or by FT-NIR (near-infrared spectroscopy) compliant with JIS K 1557-6.

Whether or not the organic substituent of the modified polydimethylsiloxane contains an OH group can also be confirmed by observing the presence or absence of an IR spectrum at approximately 1360 to 1340 cm⁻¹ derived from the bending vibration of alcoholic OH, through Fourier transform infrared spectroscopy (FT-IR) measurement of the modified polydimethylsiloxane.

Depending on the commercially available modified polydimethylsiloxane, the detailed structure of the modifying group may not be disclosed. Additionally, some substances correspond to the modified polydimethylsiloxane, although they are commercially available as various additives such as surfactants, surface control agents, leveling agents, antifoaming agents, wetting agents, and dispersing agents, and are not explicitly stated as modified polydimethylsiloxane or their structures are not disclosed. In such a case, a substance that has signals in the ranges of 0.3 to -0.3 ppm and 4.4 to 3.2 ppm and has a signal in the range of 13 to 0 ppm that disappears upon addition of D₂O in a ¹H NMR spectrum of the modified polydimethylsiloxane measured in deuterated chloroform corresponds to the modified polydimethylsiloxane of the present embodiment (the above characteristic (b)). The signal observed in the range of 0.3 to - 0.3 ppm is a signal derived from a hydrogen atom connected to a carbon atom adjacent to an Si atom. The signal observed in the range of 4.4 to 3.2 ppm is a signal derived from a hydrogen atom connected to a carbon atom adjacent to an OH group or an oxygen atom of an ether. The signal observed in the range of 13 to 0 ppm and disappearing upon addition of D₂O can be presumed to be a signal derived from a hydrogen atom of an OH group or an NH group.

The signal that disappears upon addition of D₂O is usually observed in the range of 13 to 0 ppm. Among these, a signal that is observed in the range of 3 to 2 ppm and disappears upon addition of D₂O can be presumed to be a signal derived from a hydrogen atom of an OH group.

Whether the signal that disappears upon addition of D₂O is derived from a hydrogen atom of an OH group or an NH group can also be presumed, for example, by the following methods.

### - Fourier transform infrared spectroscopy (FT-IR) measurement

In addition to the above ¹H NMR measurement, by observing the presence or absence of an IR spectrum at approximately 1360 to 1340 cm⁻¹ derived from the bending vibration of alcoholic OH through Fourier transform infrared spectroscopy (FT-IR) measurement of the modified polydimethylsiloxane, the signal that disappears upon addition of D₂O can be presumed to be a signal derived from a hydrogen atom of an OH group.

### - Measurement of acidity

In addition to the above ¹H NMR measurement, by measuring the acidity of the modified polydimethylsiloxane, it is possible to presume whether the signal that disappears upon addition of D₂O is derived from a hydrogen atom of an OH group or an NH group. For example, 100 mg of a measurement sample of the modified polydimethylsiloxane is dissolved in 200 µL of isopropyl alcohol, 200 µL of pure water is added thereto, the mixture is shaken well, and the pH of the liquid is measured. When the pH shows 3 to 7, the signal that disappears upon addition of D₂O can be presumed to be a signal derived from a hydrogen atom of an OH group. When the pH shows basicity of 8 or more, the signal that disappears upon addition of D₂O can be presumed to be a signal derived from a hydrogen atom of an NH group.

The modified polydimethylsiloxane satisfying the above characteristic (b) may have a signal in the range of 1.25 to 0.95 ppm in a ¹H NMR spectrum measured in deuterated chloroform. The signal observed in the range of 1.25 to 0.95 ppm is a signal derived from a hydrogen atom of a methyl group in a polypropylene glycol chain as a polyether modifying group. In one aspect, the modified polydimethylsiloxane has a signal in the range of 1.25 to 0.95 ppm in a ¹H NMR spectrum measured in deuterated chloroform. In one aspect, the modified polydimethylsiloxane does not have a signal in the range of 1.25 to 0.95 ppm in a ¹H NMR spectrum measured in deuterated chloroform.

Examples of the modified polydimethylsiloxane satisfying the characteristic (b) include, but are not limited to, the product name: KF-945 sold by Shin-Etsu Chemical Co., Ltd., and the product names: TEGO TWIN 4000, TEGO TWIN 4100, and the like sold by Evonik Japan Co., Ltd.

In the resin composition of the present embodiment, by containing the (D) modified polydimethylsiloxane satisfying at least one of the characteristics (a) and (b), the bleeding phenomenon is suppressed after application to a substrate or the like, not only during thermal curing but also when left at room temperature. Reasons why the bleeding phenomenon is suppressed by the resin composition containing the (D) modified polydimethylsiloxane include, but are not limited to, the following: when the resin composition containing the modified polydimethylsiloxane is applied to a substrate or the like, a part of the modified polydimethylsiloxane migrates to the surface of the coating film of the resin composition due to the surface migration property of the modified polydimethylsiloxane. Before other unreacted components seep out from the coating film of the resin composition, the modified polydimethylsiloxane that has migrated to the coating film surface slightly migrates onto the substrate not in contact with the resin composition, and the modifying groups of the modified polydimethylsiloxane are adsorbed onto the substrate surface. It is considered that, as a result, an adsorption film of the modified polydimethylsiloxane is formed on the substrate surface, and water repellency and oil repellency resulting from the polydimethylsiloxane portion are exhibited, thereby suppressing bleeding. Furthermore, it is considered that since the organic substituent as a modifying group contains a COOH group or an OH group, a higher adsorption effect of the modified polydimethylsiloxane onto the substrate can be obtained.

The ¹H NMR measurement can be performed using standard conditions. For example, 100 mg of a measurement sample is dissolved in 500 µl of deuterated chloroform, placed in a ¹H NMR sample tube with a diameter of 5 mm, and measurement is performed under the following conditions. After the measurement, 50 µl of heavy water (D₂O) is added to the sample tube containing the sample, and measurement is performed again under the same conditions. It can be understood that the signal that disappeared after the addition of heavy water is a signal derived from active hydrogen bonded to a hydroxyl group or an amino group.
Measurement frequency: 40 to 600 MHz
Solvent: Deuterated chloroform
Measured nuclide: ¹H
Number of scans: 4 to 80 times
Measurement temperature: 15 to 50°C

As the (D) polyether-modified polydimethylsiloxane, any one type may be used, or two or more types may be used in combination.

The content of the (D) modified polydimethylsiloxane is preferably 0.01% by mass or more, more preferably 0.1% by mass or more, and even more preferably 0.2% by mass or more, relative to the total mass of the resin composition. Further, it is preferably 5% by mass or less, more preferably 4% by mass or less, and even more preferably 3% by mass or less. In one aspect, the content of the (D) modified polydimethylsiloxane is preferably 0.01 to 5% by mass, more preferably 0.1 to 4% by mass, and even more preferably 0.2 to 3% by mass, relative to the total mass of the resin composition.

### (E) Filler

The resin composition of the present embodiment may contain (E) a filler (hereinafter also referred to as "component (E)") within a range that does not impair the effects of the present invention. By including the (E) filler in the resin composition, the coefficient of linear thermal expansion of a cured product obtained by curing the resin composition can be lowered, and thermal cycle resistance is improved. In addition, a filler having a low elastic modulus can relax stress generated in the cured product, improving long-term reliability. The (E) filler is broadly classified into inorganic fillers and organic fillers.

The inorganic filler is not particularly limited as long as it consists of a granular body formed of an inorganic material and has an effect of lowering the coefficient of linear thermal expansion by addition. As the inorganic material, silica, talc, alumina, aluminum nitride, calcium carbonate, aluminum silicate, magnesium silicate, magnesium carbonate, barium sulfate, barium carbonate, calcium sulfate, aluminum hydroxide, calcium silicate, potassium titanate, titanium oxide, zinc oxide, silicon carbide, silicon nitride, boron nitride, and the like can be used. Any one type of inorganic filler may be used, or two or more types may be used in combination. As the inorganic filler, it is preferable to use a silica filler because the filling amount can be increased. The silica is preferably amorphous silica.

The inorganic filler preferably has a surface treated with a coupling agent such as a silane coupling agent. Thereby, the viscosity of the resin composition can be adjusted to an appropriate range.

Examples of the organic filler include polytetrafluoroethylene (PTFE) fillers, silicone fillers, acrylic fillers, styrene fillers, and the like. The organic filler may be surface-treated. The glass transition point of the organic filler is preferably higher than 40°C.

The shape of the filler is not particularly limited, and may be any of spherical, flaky, needle-like, amorphous, and the like.

In one aspect, the average particle size of the filler is preferably 5.0 µm or less, more preferably 4.0 µm or less, and even more preferably 3.0 µm or less. In the present specification, the average particle size refers to a value determined as a volume-based median diameter (d₅₀) measured by a laser diffraction method in accordance with ISO-13320 (2009), or as a number average of 50 measurement values arbitrarily selected from an observation image obtained by a transmission electron microscope (TEM) or a scanning electron microscope (SEM). By setting the average particle size of the filler to the upper limit or less, sedimentation of the filler can be suppressed, and also formation of coarse particles can be suppressed, whereby clogging of a nozzle of a dispenser can be suppressed. The lower limit of the average particle size of the filler is not particularly limited, but from the viewpoint of the viscosity of the resin composition, it is preferably 0.005 µm or more, and more preferably 0.1 µm or more. In one aspect of the present embodiment, the average particle size of the filler is preferably 0.01 µm to 5.0 µm, and more preferably 0.1 µm to 3.0 µm. Fillers having different average particle sizes may be used in combination. For example, a filler having an average particle size of 0.005 µm or more and less than 0.1 µm and a filler having an average particle size of 0.1 µm to 5.0 µm may be used in combination.

The content of the (E) filler in the resin composition of the present embodiment is preferably 0.5 to 80% by mass, more preferably 1 to 70% by mass, and even more preferably 3 to 60% by mass, relative to the total mass of the resin composition. By setting the content of the (E) filler within the above range, the thermal cycle resistance is improved, and the viscosity of the resin composition is adjusted to an appropriate range, improving applicability with a dispenser.

### (F) Stabilizer

The resin composition of the present embodiment may contain (F) a stabilizer (hereinafter also referred to as "component (F)") within a range that does not impair the effects of the present invention. The (F) stabilizer is for increasing the stability of the resin composition during storage, and is added to suppress the occurrence of polymerization reactions caused by unintended radicals or basic components. Typically, examples of the (F) stabilizer include radical polymerization inhibitors and anionic polymerization inhibitors.

As the radical polymerization inhibitor, known ones can be used, and for example, at least one selected from N-nitroso-N-phenylhydroxylamine aluminum, triphenylphosphine, p-methoxyphenol, and hydroquinone can be used. Further, known radical polymerization inhibitors disclosed in JP 2010-117545 A, JP 2008-184514 A, and the like can also be used. As the radical polymerization inhibitor, any one type may be used, or two or more types may be used in combination.

When the radical polymerization inhibitor is contained, the content of the radical polymerization inhibitor is preferably 0.0001 to 5% by mass, and more preferably 0.001 to 3% by mass, relative to the total mass of the resin composition, from the viewpoint of pot life.

As the anionic polymerization inhibitor, known ones can be used, and for example, borate ester compounds and strong acids can be used. Specific examples of the anionic polymerization inhibitor include trimethyl borate, triethyl borate, tri-n-propyl borate, triisopropyl borate, trifluoromethanesulfonic acid, maleic acid, methanesulfonic acid, barbituric acid, difluoroacetic acid, trichloroacetic acid, phosphoric acid, dichloroacetic acid, and the like. Among these, a preferred anionic polymerization inhibitor is at least one selected from tri-n-propyl borate, triisopropyl borate, and barbituric acid. Further, as the anionic polymerization inhibitor, known ones disclosed in JP 2010-117545 A, JP 2008-184514 A, JP 2017-171804 A, and the like can also be used. As the anionic polymerization inhibitor, any one type may be used, or two or more types may be used in combination.

When the anionic polymerization inhibitor is contained, the content of the anionic polymerization inhibitor is preferably 0.001 to 5% by mass, and more preferably 0.01 to 3% by mass, relative to the total mass of the resin composition.

The resin composition may further contain a coupling agent, carbon black, titanium black, an ion trapping agent, a leveling agent, an antioxidant, a defoaming agent, a thixotropic agent, a viscosity modifier, a flame retardant, and/or other additives, as necessary, within a range that does not impair the object of the present embodiment. However, from the viewpoint of preventing a reduction in curing strength, it is preferable that the resin composition substantially contains no solvent; for example, the content of the solvent is 1% by mass or less relative to the total mass of the resin composition. Moreover, this can reduce the amount of volatile organic compounds (VOCs). Examples of the solvent include organic solvents common in the field of curable compositions, such as hydrocarbons (benzene, toluene, xylene, cyclohexane, etc.), aprotic polar solvents (N,N-dimethylformamide, dimethyl sulfoxide, N-methyl-2-pyrrolidone, etc.), nitriles (acetonitrile, etc.), ketones (acetone, methyl ethyl ketone, methyl isobutyl ketone, cyclohexanone, etc.), esters (ethyl acetate, butyl acetate, etc.), ethers (cyclopentyl methyl ether, diethyl ether, tetrahydrofuran, dimethoxyethane, etc.), alcohols (methanol, ethanol, propanol, butanol, etc.), terpenes (turpentine oil, terpineol, isobornyl acetate, etc.), and halogen-based solvents (dichloromethane, chloroform, etc.).

The resin composition can be obtained, for example, by stirring, melting, mixing, and/or dispersing the component (A) to the component (D), and if necessary, the component (E), the component (F), other additives, and the like, simultaneously or separately, while applying heat treatment as necessary. The apparatus for mixing, stirring, dispersing, and the like of these components is not particularly limited. As this apparatus, a raikai mixer, a Henschel mixer, a three-roll mill, a ball mill, a planetary mixer, a bead mill, or the like equipped with stirring and heating devices can be used. Further, these apparatuses may be used in appropriate combination.

The resin composition thus obtained is photocurable, thermosetting, or photo- and thermosetting, depending on the type of the (C) polymerization initiator contained in the resin composition. Photo curing of the resin composition is performed, for example, by irradiating the resin composition with UV light. Thermosetting of the resin composition is performed, for example, under a condition of a temperature of 100°C. The thermosetting temperature of the resin composition is preferably 60 to 90°C when the resin composition is used for producing a semiconductor module (for example, an optical sensor module or a camera module) including a component that deteriorates under high-temperature conditions. The thermosetting time depends on other curing conditions, but may be, for example, 30 to 120 minutes. When the resin composition is photo- and thermosetting, for example, the resin composition can be precured by curing with light (UV) and then main-cured by curing with heat.

The resin composition of the present embodiment can be used, for example, as an adhesive, a sealing material, a damming agent for fixing, bonding, or protecting components, and as a raw material thereof, and is suitable as a one-component type. Here, the damming agent is formed, for example, on the outer periphery of a substrate in advance before sealing a plurality of semiconductor chips or the like on the substrate with a low-viscosity filling agent or the like. By forming a dam with this damming agent, it is possible to suppress the outflow of the low-viscosity filling agent that subsequently seals the plurality of semiconductor chips. Furthermore, the adhesive containing the resin composition of the present embodiment enables good bonding relative to engineering plastics, ceramics, and metals as well.

### [Adhesive or Sealing Material]

The adhesive or sealing material according to one embodiment of the present invention contains the resin composition of the above-described embodiment. This adhesive or sealing material enables good bonding relative to engineering plastics, ceramics, and metals. The adhesive or sealing material of the present embodiment is preferably used for fixing, bonding, or protecting components constituting an optical sensor module or a camera module.

### [Cured Product of Resin Composition or Adhesive or Sealing Material]

A cured product according to another embodiment of the present invention is a cured product obtained by curing the resin composition of the above-described embodiment or the adhesive or sealing material of the above-described embodiment. Bleeding is suppressed around an adherend to which this cured product is bonded.

### [Semiconductor Device, Electronic Component]

A semiconductor device or an electronic component according to one embodiment of the present invention includes the cured product of the above-described embodiment. Here, the semiconductor device refers to all devices that can function by utilizing semiconductor characteristics, and includes electronic components, semiconductor circuits, modules incorporating these, electronic devices, and the like. Examples of the semiconductor device or the electronic component include, but are not limited to, HDDs, semiconductor elements, optical sensor modules, camera modules, semiconductor modules, integrated circuits, and the like. Examples of the optical sensor include, but are not limited to, photodiodes, photo-ICs, photomultiplier tubes (PMTs), phototubes, image sensors, spectrometers/spectral sensors, infrared sensors, ultraviolet/flame sensors, X-ray sensors, radiation sensors, electron/ion sensors, distance/position sensors, and the like.

### Examples

Hereinafter, the present invention will be described in more detail with reference to examples and comparative examples, but the present invention is not limited to these examples. In the following examples, "part(s)" and "%" indicate "part(s) by mass" and "% by mass," respectively, unless otherwise specified.

### [Preparation of Resin Composition]

Resin compositions of Examples and Comparative Examples were prepared by mixing predetermined amounts of each component using a three-roll mill according to the formulations shown in Tables 2-1 to 2-5. In Tables 2-1 to 2-5, the amount of each component is expressed in parts by mass (unit: g). The components used in the Examples and Comparative Examples are as follows.

### - (A) Polymerizable compound having a carbon-carbon double bond (component (A))

(A-1): Polyester acrylate (product name: M7100, manufactured by Toagosei Co., Ltd., (meth)acryloyl equivalent: 188 g/eq)
(A-2): Dimethylol-tricyclodecane diacrylate (product name: Light Acrylate DCP-A, manufactured by Kyoeisha Chemical Co., Ltd., (meth)acryloyl equivalent: 152 g/eq)
(A-3): 2-(o-phenylphenoxy)ethyl acrylate (product name: HRD-01, manufactured by Nisshoku Techno Fine Chemical Co., Ltd., (meth)acryloyl equivalent: 268 g/eq)
(A-4): Ethoxylated bisphenol A diacrylate (product name: ABE-300, manufactured by Shin-Nakamura Chemical Co., Ltd., (meth)acryloyl equivalent: 236 g/eq)

### - (B) Polythiol compound (component (B))

(B-1): Thiol glycoluril derivative (product name: C3 TS-G, manufactured by Shikoku Chemicals Corporation, thiol equivalent: 114 g/eq)
(B-2): Thiol glycoluril derivative (product name: TS-G, manufactured by Shikoku Chemicals Corporation, thiol equivalent: 100 g/eq)
(B-3): Pentaerythritol tetrakis(3-mercaptopropionate) (product name: PEMP, manufactured by SC Organic Chemical Co., Ltd., thiol equivalent: 122 g/eq)

### - (C) Polymerization initiator (component (C))

(C1-1): Amine-epoxy adduct-based latent curing catalyst (product name: Novacure HXA9322HP, manufactured by Asahi Kasei Corporation)
(C1-2): Amine-urea type adduct-based latent curing catalyst (product name: Fujicure FXR-1121, solid at room temperature, manufactured by T&K TOKA CO., LTD.)
(C3-1): 1-Hydroxy-cyclohexyl-phenyl-ketone (product name: Omnirad 184, manufactured by IGM Resins B.V.)

### - (D) Modified polydimethylsiloxane (component (D))

### - (D') Modified polydimethylsiloxane other than the component (D) (component (D'))

As the component (D) and the component (D'), modified polydimethylsiloxanes described in Table 1 below were used. Table 1 shows the results of ¹H-NMR measurement in deuterochloroform, Fourier transform infrared spectroscopy (FT-IR) measurement, and acidity measurement for various modified polydimethylsiloxanes.

### [Table 1]

**Table 1**

| Component | Distributor | Product Name | Information Disclosed by Distributor | Substituent at Terminal of Modified Group | Integral value of 1H NMR signals | | | Chemical shift of 1H NMR signals that disappeared upon addition of heavy water (ppm) | | FT-IR | | Acidity |
|---|---|---|---|---|---|---|---|---|---|---|---|---|
| | | | | | 0.3~-0.3ppm | 4 .4~3.2ppm | 1.25~0.95ppm (d. approx. 6Hz) | Chemical shift (ppm) | Integral value | (C=O stretching derived from carboxylic acid) | (OH bending vibration) | (IPA/water suspension, pH test paper) |
| (D-1) | Shin-Etsu Chemical Co., Ltd. | KF-6013 | PEG-9 Dimethicone | OH | 6 | 6.6 | ND | 2.77 | 0.3 | ND | 1350 cm-1 | pH3-7 |
| (D-2) | Shin-Etsu Chemical Co., Ltd. | KF-6015 | PEG-3 Dimethicone | OH | 6 | 1.7 | ND | 2.64 | 0.2 | ND | 1350 cm-1 | pH3-7 |
| (D-3) | Shin-Etsu Chemical Co., Ltd. | KF-6017 | PEG-10 Dimethicone | OH | 6 | 2.1 | ND | 2.5 | 0.2 | ND | 1350 cm-1 | pH3-7 |
| (D-4) | Shin-Etsu Chemical Co., Ltd. | KF-6043 | PEG-10 Dimethicone | OH | 6 | 17.9 | ND | 2.77 | 0.9 | ND | 1349 cm-1 | pH3-7 |
| (D-5) | Shin-Etsu Chemical Co., Ltd. | KF-6123 | Hydroxyl value: 50 mgKOH/g | OH | 6 | 5.4 | ND | 2.74, 2.46 | 0.3 | ND | 1350 cm-1 | pH3-7 |
| (D-6) | Shin-Etsu Chemical Co., Ltd. | KF-945 | Polyether-modified dimethylpolysiloxane silicone oil | Not disclosed | 6 | 1.7 | ND | 2.47 | 0.1 | ND | 1350 cm-1 | pH3-7 |
| (D-7) | Shin-Etsu Chemical Co., Ltd. | X-22-4272 | Hydroxyl value: 50 mgKOH/g | OH | 6 | 4.4 | ND | 2.75 | 0.1 | ND | 1350 cm-1 | pH3-7 |
| (D-8) | Shin-Etsu Chemical Co., Ltd. | X-22-3701E | Side-chain type / Carboxyl-modified (Reactive silicone oil) | COOH | 6 | ND | ND | ND | ND | 1715 cm-1 | ND | pH3-7 |
| (D-9) | Shin-Etsu Chemical Co., Ltd. | X-22-4039 | Side-chain type / Carbinol-modified (Reactive silicone oil) | OH | 6 | 0.6 | ND | 2.08 | 0.1 | ND | 1358 cm⁻¹ | pH3~7 |
| (D-10) | Evonik Japan Co., Ltd. | TEGO TWIN 4000 | Siloxane-based twin-structure surfactant | Not disclosed | 6 | 2.4 | ND | 2.76 | 0.4 | ND | 1353 cm-1 | pH3-7 |
| (D-11) | Evonik Japan Co., Ltd. | TEGO TWIN 4100 | Gemini-structure additive with a polysiloxane skeleton | Not disclosed | 6 | 6.3 | 0.3 | 2.99 | 0.9 | ND | 1353 cm-1 | pH3-7 |
| (D'-1) | BYK Japan KK | BYK-378 | Polyether-modified dimethylpolysiloxane | Not disclosed | 6 | 9.4 | 3.6 | ND | ND | ND | ND | pH3-7 |
| (D'-2) | Shin-Etsu Chemical Co., Ltd. | KF-53 | Diphenyl dimethicone | Ph | 6 | ND | ND | ND | ND | ND | ND | pH3-7 |
| (D'-3) | Shin-Etsu Chemical Co., Ltd. | KF-4418 | Caprylyl methicone | alkyl | 6 | ND | ND | ND | ND | ND | ND | pH3-7 |
| (D'-4) | Shin-Etsu Chemical Co., Ltd. | KF-6011 | PEG-11 methyl ether dimethicone | Me | 6 | 18.0 | ND | ND | ND | ND | ND | pH3-7 |
| ND: Not detected | | | | | | | | | | | | |

In Table 1, "Ph" represents a phenyl group and "Me" represents a methyl group.

### - (E) Filler (component (E))

(E-1): Calcium carbonate filler (product name: CS3NA, manufactured by Ube Materials Industries, Ltd.)
(E-2): Silica filler (product name: CAB-O-SIL^{®} TS-720, polydimethylsiloxane surface-treated fumed silica, manufactured by Cabot Corporation)

### [¹H NMR Measurement of Modified Polydimethylsiloxane]

100 mg of a measurement sample of each modified polydimethylsiloxane was dissolved in 500 µL of deuterochloroform, placed in a ¹H NMR sample tube with a diameter of 5 mm, and measurement was performed under the following conditions. After the measurement, 50 µL of heavy water (D₂O) was added to the sample tube containing the sample, and measurement was performed again under the same conditions. Table 1 shows the integral value of each signal when the value obtained by integrating signals of 0.3 to -0.3 ppm in the signal derived from chloroform is set to 6.
Measurement apparatus: Oxford Instrument Pulsar HF
Measurement frequency: 60 MHz
Solvent: Deuterochloroform
Measured nuclide: ¹H
Measurement temperature: 37°C
Number of integrations: 32 times

Examples of assignment of each signal under the above measurement conditions are as follows.
0.3 to -0.3 ppm: CH₃-Si, CH₂-Si (hydrogen atoms connected to a carbon atom adjacent to a silicon atom)
4.4 to 3.2 ppm: -CH₂-O-, -C=C-CH₂-O- (hydrogen atoms connected to a carbon atom adjacent to an oxygen atom of an alcohol or an ether)
1.1 ppm (d, approx. 6 Hz): -CH₂-CHCH₃-O- (hydrogen atoms of a methyl group of propylene glycol)

Signals that appear in the range of 9.0 to 0.5 ppm under the above measurement conditions and disappear upon addition of D₂O: OH group or NH group

### [Fourier Transform Infrared Spectroscopy (FT-IR) Measurement of Modified Polydimethylsiloxane]

The Fourier transform infrared spectroscopy (FT-IR) measurement of the various modified polydimethylsiloxanes was performed under the following conditions to confirm the presence or absence of the C=O stretching vibration (approximately 1715 cm⁻¹) of carboxylic acid and the presence or absence of the bending vibration (approximately 1360 to 1340 cm⁻¹) of alcoholic OH. The results are shown in Table 1.
Measurement apparatus: Perkin-Elmer FT-IR Spectrometer Spectrum 3
Measurement method: ATR method

### [Acidity Measurement of Modified Polydimethylsiloxane]

100 mg of a sample of each modified polydimethylsiloxane was dissolved in 200 µL of isopropyl alcohol (IPA), and 200 µL of pure water was added thereto, followed by thorough shaking. A pH test paper was immersed in the resulting liquid to determine the pH. As the pH test paper, Macherey Nagel #90204 Universal indicator paper was used. The results are shown in Table 1.

In the Examples and Comparative Examples, properties of the resin compositions were measured as follows.

### [Bleed Evaluation]

1.5 mg of the resin composition of each of the Examples and Comparative Examples was potted with a dispenser onto a ceramic substrate that had been subjected to plasma treatment with argon (Ar) gas. Hereinafter, bleed lengths under two conditions were measured with a CCD camera (N=3 pcs x 2 sides). The results are shown in Tables 2-1 to 2-5.
Condition 1: The bleed length generated on the ceramic substrate after potting and then leaving the resin composition at room temperature (20°C to 25°C) for 60 minutes.
Condition 2: The bleed length generated on the ceramic substrate after potting, leaving the resin composition at room temperature (20°C to 25°C) for 60 minutes, and then thermosetting the resin composition under conditions of 80°C for 60 minutes.

**[Table 2-1]**

| | | Ex.1 | Ex.2 | Ex.3 | Ex.4 | Ex.5 | Ex.6 |
|---|---|---|---|---|---|---|---|
| (A) Polymerizable compound having a carbon-carbon double bond | (A-1) | 18.6 | 18.6 | 18.6 | 18.6 | 18.6 | 18.6 |
| | (A-2) | 18.8 | 18.8 | 18.8 | 18.8 | 18.8 | 18.8 |
| | (A-3) | 6.6 | 6.6 | 6.6 | 6.6 | 6.6 | 6.6 |
| | (A-4) | | | | | | |
| (B) Polythiol | (B-1) | 29.0 | 29.0 | 29.0 | 29.0 | 29.0 | 29.0 |
| | (B-2) | | | | | | |
| | (B-3) | | | | | | |
| (C) Polymerization initiator | (C1-1) | 4.5 | 4.5 | 4.5 | 4.5 | 4.5 | 4.5 |
| | (C1-2) | | | | | | |
| | (C3-1) | 2.0 | 2.0 | 2.0 | 2.0 | 2.0 | 2.0 |
| (D) Modified polydimethylsil oxane satisfying at least one of the characteristics (a) and (b) | (D-1) | 0.5 | | | | | |
| | (D-2) | | 0.5 | | | | |
| | (D-3) | | | 0.5 | | | |
| | (D-4) | | | | 0.5 | | |
| | (D-5) | | | | | 0.5 | |
| | (D-6) | | | | | | 0.5 |
| | (D-7) | | | | | | |
| | (D-8) | | | | | | |
| | (D-9) | | | | | | |
| | (D-10) | | | | | | |
| | (D-11) | | | | | | |
| | (D-12) | | | | | | |
| (D') Modified polydimethylsilo xane other than the component (D) | (D'-1) | | | | | | |
| | (D'-2) | | | | | | |
| | (D'-3) | | | | | | |
| | (D'-5) | | | | | | |
| (E) Filler | (E-1) | 10.0 | 10.0 | 10.0 | 10.0 | 10.0 | 10.0 |
| | (E-2) | 10.0 | 10.0 | 10.0 | 10.0 | 10.0 | 10.0 |
| Total | | 100.0 | 100.0 | 100.0 | 100.0 | 100.0 | 100.0 |
| Condition 1: Bleed length (µm) | | 0 | 0 | 50 | 100 | 30 | 20 |
| Condition 2: Bleed length (µm) | | 20 | 30 | 80 | 200 | 40 | 80 |

**[Table 2-2]**

| | | Ex.7 | Ex.8 | Ex.9 | Ex.10 | Ex.11 | Ex.12 |
|---|---|---|---|---|---|---|---|
| (A) Polymerizable compound having a carbon-carbon double bond | (A-1) | 18.6 | 18.6 | 18.6 | 18.6 | 18.6 | 18.7 |
| | (A-2) | 18.8 | 18.8 | 18.8 | 18.8 | 18.8 | 18.9 |
| | (A-3) | 6.6 | 6.6 | 6.6 | 6.6 | 6.6 | 6.7 |
| | (A-4) | | | | | | |
| (B) Polythiol | (B-1) | 29.0 | 29.0 | 29.0 | 29.0 | 29.0 | 29.2 |
| | (B-2) | | | | | | |
| | (B-3) | | | | | | |
| (C) Polymerization initiator | (C1-1) | 4.5 | 4.5 | 4.5 | 4.5 | 4.5 | 4.5 |
| | (C1-2) | | | | | | |
| | (C3-1) | 2.0 | 2.0 | 2.0 | 2.0 | 2.0 | 2.0 |
| (D) Modified polydimethylsil oxane satisfying at least one of the characteristics (a) and (b) | (D-1) | | | | | | |
| | (D-2) | | | | | | |
| | (D-3) | | | | | | |
| | (D-4) | | | | | | |
| | (D-5) | | | | | | |
| | (D-6) | | | | | | |
| | (D-7) | 0.5 | | | | | |
| | (D-8) | | 0.5 | | | | |
| | (D-9) | | | 0.5 | | | |
| | (D-10) | | | | 0.5 | | 0.1 |
| | (D-11) | | | | | 0.5 | |
| | (D-12) | | | | | | |
| (D') Modified polydimethylsilo xane other than the component (D) | (D'-1) | | | | | | |
| | (D'-2) | | | | | | |
| | (D'-3) | | | | | | |
| | (D'-5) | | | | | | |
| (E) Filler | (E-1) | 10.0 | 10.0 | 10.0 | 10.0 | 10.0 | 10.0 |
| | (E-2) | 10.0 | 10.0 | 10.0 | 10.0 | 10.0 | 10.0 |
| Total | | 100.0 | 100.0 | 100.0 | 100.0 | 100.0 | 100.0 |
| Condition 1: Bleed length (µm) | | 20 | 0 | 80 | 0 | 0 | 20 |
| Condition 2: Bleed length (µm) | | 40 | 10 | 130 | 20 | 20 | 40 |

**[Table 2-3]**

| | | Ex.13 | Ex.14 | Ex.15 | Ex.16 | Ex.17 | Ex.18 | Ex.19 | Ex.20 |
|---|---|---|---|---|---|---|---|---|---|
| (A) Polymerizable compound having a carbon-carbon double bond | (A-1) | 23.9 | | 25.8 | 27.2 | 27.2 | 26.0 | 24.6 | 31.3 |
| | (A-2) | 19.3 | | 21.7 | 22.0 | 22.0 | 21.0 | 19.9 | 25.3 |
| | (A-3) | | | | | | | | |
| | (A-4) | | 48.5 | | | | | | |
| (B) Polythiol | (B-1) | 11.9 | 24.5 | 9.3 | 13.5 | 13.5 | 12.2 | 12.2 | 15.4 |
| | (B-2) | 8.0 | | 19.2 | 9.0 | 9.0 | 8.1 | 8.2 | 10.3 |
| | (B-3) | 9.9 | | | 11.2 | 11.2 | 10.1 | 10.2 | 12.8 |
| (C) Polymerization initiator | (C1-1) | 4.5 | 4.5 | | 4.5 | 4.5 | | 4.5 | 4.5 |
| | (C1-2) | | | 1.5 | | | | | |
| | (C3-1) | 2.0 | 2.0 | 2.0 | 2.0 | 2.0 | 2.0 | | |
| (D) Modified polydimethylsil oxane satisfying at least one of the characteristics (a) and (b) | (D-1) | 0.5 | 0.5 | 0.5 | 0.5 | 0.5 | 0.5 | 0.5 | 0.5 |
| | (D-2) | | | | | | | | |
| | (D-3) | | | | | | | | |
| | (D-4) | | | | | | | | |
| | (D-5) | | | | | | | | |
| | (D-6) | | | | | | | | |
| | (D-7) | | | | | | | | |
| | (D-8) | | | | | | | | |
| | (D-9) | | | | | | | | |
| | (D-10) | | | | | | | | |
| | (D-11) | | | | | | | | |
| | (D-12) | | | | | | | | |
| (D') Modified polydimethylsilo xane other than the component (D) | (D'-1) | | | | | | | | |
| | (D'-2) | | | | | | | | |
| | (D'-3) | | | | | | | | |
| | (D'-5) | | | | | | | | |
| (E) Filler | (E-1) | 10.0 | 10.0 | 10.0 | | 10.0 | 10.0 | 10.0 | |
| | (E-2) | 10.0 | 10.0 | 10.0 | 10.0 | | 10.0 | 10.0 | |
| Total | | 100.0 | 100.0 | 100.0 | 100.0 | 100.0 | 100.0 | 100.0 | 100.0 |
| Condition 1: Bleed length (µm) | | 0 | 0 | 0 | 0 | 0 | 0 | 0 | 0 |
| Condition 2: Bleed length (µm) | | 20 | 20 | 20 | 20 | 20 | - | 20 | 20 |

**[Table 2-4]**

| | | Com.Ex.1 | Com.Ex.2 | Com.Ex.3 | Com.Ex.4 | Com.Ex.5 | Com.Ex.6 |
|---|---|---|---|---|---|---|---|
| (A) Polymerizable compound having a carbon-carbon double bond | (A-1) | 18.7 | 18.6 | 18.6 | 18.6 | 18.6 | 26.0 |
| | (A-2) | 18.9 | 18.8 | 18.8 | 18.8 | 18.8 | 21.9 |
| | (A-3) | 6.7 | 6.6 | 6.6 | 6.6 | 6.6 | |
| | (A-4) | | | | | | |
| (B) Polythiol | (B-1) | 29.2 | 29.0 | 29.0 | 29.0 | 29.0 | 9.3 |
| | (B-2) | 0.0 | 0.0 | 0.0 | 0.0 | 0.0 | 19.4 |
| | (B-3) | 0.0 | 0.0 | 0.0 | 0.0 | 0.0 | 0.0 |
| (C) Polymerization initiator | (C1-1) | 4.5 | 4.5 | 4.5 | 4.5 | 4.5 | 0.0 |
| | (C1-2) | | | | | | 1.5 |
| | (C3-1) | 2.0 | 2.0 | 2.0 | 2.0 | 2.0 | 2.0 |
| (D) Modified polydimethylsil oxane satisfying at least one of the characteristics (a) and (b) | (D-1) | | | | | | |
| | (D-2) | | | | | | |
| | (D-3) | | | | | | |
| | (D-4) | | | | | | |
| | (D-5) | | | | | | |
| | (D-6) | | | | | | |
| | (D-7) | | | | | | |
| | (D-8) | | | | | | |
| | (D-9) | | | | | | |
| | (D-10) | | | | | | |
| | (D-11) | | | | | | |
| | (D-12) | | | | | | |
| (D') Modified polydimethylsilo xane other than the component (D) | (D'-1) | | 0.5 | | | | |
| | (D'-2) | | | 0.5 | | | |
| | (D'-3) | | | | 0.5 | | |
| | (D'-5) | | | | | 0.5 | |
| (E) Filler | (E-1) | 10.0 | 10.0 | 10.0 | 10.0 | 10.0 | 10.0 |
| | (E-2) | 10.0 | 10.0 | 10.0 | 10.0 | 10.0 | 10.0 |
| Total | | 100.0 | 100.0 | 100.0 | 100.0 | 100.0 | 100.0 |
| Condition 1: Bleed length (µm) | | 740 | 530 | 650 | 780 | 500 | 670 |
| Condition 2: Bleed length (µm) | | 1240 | 1120 | 1130 | 1250 | 1140 | 1120 |

**[Table 2-5]**

| | | Com.Ex.7 | Com.Ex.8 | Com.Ex.9 | Com.Ex.10 | Com.Ex.11 |
|---|---|---|---|---|---|---|
| (A) Polymerizable compound having a carbon-carbon double bond | (A-1) | 27.4 | 27.4 | 26.9 | 24.7 | 31.4 |
| | (A-2) | 22.2 | 22.2 | 21.7 | 20.0 | 25.4 |
| | (A-3) | | | | | |
| | (A-4) | | | | | |
| (B) Polythiol | (B-1) | 13.6 | 13.6 | 12.6 | 12.3 | 15.5 |
| | (B-2) | 9.1 | 9.1 | 8.4 | 8.2 | 10.3 |
| | (B-3) | 11.3 | 11.3 | 10.5 | 10.3 | 12.9 |
| (C) Polymerization initiator | (C1-1) | 4.5 | 4.5 | | 4.5 | 4.5 |
| | (C1-2) | | | | | |
| | (C3-1) | 2.0 | 2.0 | | | |
| (D) Modified polydimethylsil oxane satisfying at least one of the characteristics (a) and (b) | (D-1) | | | | | |
| | (D-2) | | | | | |
| | (D-3) | | | | | |
| | (D-4) | | | | | |
| | (D-5) | | | | | |
| | (D-6) | | | | | |
| | (D-7) | | | | | |
| | (D-8) | | | | | |
| | (D-9) | | | | | |
| | (D-10) | | | | | |
| | (D-11) | | | | | |
| | (D-12) | | | | | |
| (D') Modified polydimethylsilo xane other than the component (D) | (D'-1) | | | | | |
| | (D'-2) | | | | | |
| | (D'-3) | | | | | |
| | (D'-5) | | | | | |
| (E) Filler | (E-1) | | 10.0 | 10.0 | 10.0 | |
| | (E-2) | 10.0 | | 10.0 | 10.0 | |
| Total | | 100.0 | 100.0 | 100.0 | 100.0 | 100.0 |
| Condition 1: Bleed length (µm) | | 860 | 910 | 800 | 800 | 1000 |
| Condition 2: Bleed length (µm) | | 1460 | 1550 | - | 1400 | 1750 |

It can be seen that the resin compositions of Examples 1 to 20 containing the (D) modified polydimethylsiloxane satisfying at least one of the characteristics (a) and (b) significantly suppressed the bleeding phenomenon under both Condition 1 and Condition 2, as compared with the resin compositions of Comparative Examples 1 and 6 to 11 not containing the (D) modified polydimethylsiloxane and the resin compositions of Comparative Examples 2 to 5 containing the (D') component or a modified polydimethylsiloxane other than the (D) component.

### Industrial Applicability

The present invention is a resin composition that is at least photocurable or thermosetting and capable of suppressing the bleeding phenomenon, and is extremely useful as an adhesive or a sealing material used for fixing, bonding, or protecting components of a semiconductor module that is particularly downsized or highly integrated.

The disclosure of Japanese Patent Application No. 2023-211994(filing date: December 15, 2023) is incorporated herein by reference in its entirety.

All references, patent applications, and technical standards described herein are incorporated herein by reference to the same extent as if the individual references, patent applications, and technical standards were specifically and individually noted as being incorporated by reference.

## Claims

1. A resin composition comprising:
(A) a polymerizable compound having a carbon-carbon double bond;
(B) a polythiol compound;
(C) a polymerization initiator; and
(D) a modified polydimethylsiloxane satisfying at least one of the following characteristics (a) and (b):
(a) an organic substituent containing a COOH group or an OH group is bonded to the polydimethylsiloxane directly or via a linker;
(b) in a ¹H NMR spectrum measured in deuterated chloroform, the modified polydimethylsiloxane has signals in ranges of 0.3 to -0.3 ppm and 4.4 to 3.2 ppm, and has a signal in a range of 13 to 0 ppm that disappears by addition of D₂O.

2. The resin composition according to claim 1, wherein the (A) polymerizable compound having a carbon-carbon double bond is a (meth)acrylate compound.

3. The resin composition according to claim 1 or 2, wherein a content of the (D) modified polydimethylsiloxane is 0.01 to 5% by mass relative to the total mass of the resin composition.

4. The resin composition according to any one of claims 1 to 3, further comprising (E) a filler.

5. An adhesive or a sealing material comprising the resin composition according to any one of claims 1 to 4.

6. The adhesive or the sealing material according to claim 5, used for fixing, bonding, or protecting an optical sensor module or a component constituting the same.

7. A cured product in which the resin composition according to any one of claims 1 to 4, or the adhesive or the sealing material according to claim 5 or 6 has been cured.

8. A semiconductor device or an electronic component comprising the cured product according to claim 7.

9. The semiconductor device or the electronic component according to claim 8, which is an optical sensor module.
